# EUROPEAN PATENT APPLICATION

(11) **EP 4 686 330 A1**
(43) Date of publication of application: **28.01.2026**
(21) Application number: 25188214.8
(22) Date of filing: 08.07.2025
(51) Int. Cl.: H05K 7/20

(54) **SYSTEMS FOR COOLING MODULE WITH COOLING FINS**

(30) Priority: 22.07.2024 US 202463673850 P; 28.02.2025 US 202519066876
(71) Applicant: BorgWarner US Technologies LLC, Wilmington, DE 19801 (US)
(72) Inventor: CHOI, Edward, Lake Orion, MI (US); CHOI, Jeehoon, Carmel, IN (US)
(74) Representative: Office Freylinger

(57) **Abstract**

A cooling module includes: first cooling fins with a first cooling fin geometry, second cooling fins with a second cooling fin geometry, the second cooling fins downstream of the first cooling fins along a flow of coolant from an inlet port to an outlet port, and third cooling fins with a third cooling fin geometry, the third cooling fins downstream of the second cooling fins along the flow of coolant from the inlet port to the outlet port, wherein the first cooling fin geometry is a first sinusoidal wave having a first uniform wavelength, the second cooling fin geometry is a second sinusoidal wave having a second uniform wavelength that is shorter than the first uniform wavelength, and the third cooling fin geometry is a third sinusoidal wave having a third uniform wavelength that is longer than the second uniform wavelength.

## Description

### CROSS REFERENCE TO RELATED APPLICATION(S)

This application claims the benefit of priority to U.S. Provisional Patent Application No. 63/673,850, filed July 22, 2024, the entirety of which is incorporated by reference herein.

### TECHNICAL FIELD

Various embodiments of the present disclosure relate generally to a cooling module, and more specifically, to systems for providing thermal management and cooling fins on a cooling module for reducing the temperature in a power module.

### BACKGROUND

Thermal management is considered a key technical aspect in an electric vehicle system. A cooling module may therefore be a critical component in a power converter system, which controls the performance and efficiency of an overall driving system of an electric vehicle. However, some cooling modules may have limited capability for thermal performance optimization and may have high pressure drop.

The present disclosure is directed to overcoming one or more of these above referenced challenges.

### SUMMARY OF THE DISCLOSURE

In some aspects, the techniques described herein relate to a heat sink system including: a first heat sink including: a container including a cavity; a housing connecting to the container to cover the cavity, wherein one or more of the container or the housing includes an inlet port, and one or more of the container or the housing includes an outlet port; and a cooling module in the cavity between the container and the housing, the cooling module in a flow of coolant from the inlet port to the outlet port, wherein the cooling module includes: first cooling fins with a first cooling fin geometry, second cooling fins with a second cooling fin geometry, the second cooling fins downstream of the first cooling fins along the flow of coolant from the inlet port to the outlet port, and third cooling fins with a third cooling fin geometry, the third cooling fins downstream of the second cooling fins along the flow of coolant from the inlet port to the outlet port, wherein the first cooling fin geometry is a first sinusoidal wave having a first uniform wavelength, the second cooling fin geometry is a second sinusoidal wave having a second uniform wavelength that is shorter than the first uniform wavelength, and the third cooling fin geometry is a third sinusoidal wave having a third uniform wavelength that is longer than the second uniform wavelength.

In some aspects, the techniques described herein relate to a heat sink system, further including: one or more power modules, wherein the first heat sink is provided on the one or more power modules.

In some aspects, the techniques described herein relate to a heat sink system, further including: a second heat sink, wherein the one or more power modules include: a first power module; a second power module; a third power module; a fourth power module; a fifth power module; and a sixth power module, wherein the first heat sink is provided on a first side surface of the first power module, a first side surface of the second power module, a first side surface of the third power module, a first side surface of the fourth power module, a first side surface of the fifth power module, and a first side surface of the sixth power module, and wherein the second heat sink is provided on a second side surface of the first power module, a second side surface of the second power module, a second side surface of the third power module, a second side surface of the fourth power module, a second side surface of the fifth power module, and a second side surface of the sixth power module.

In some aspects, the techniques described herein relate to an inverter including the heat sink system.

In some aspects, the techniques described herein relate to a vehicle including the inverter.

In some aspects, the techniques described herein relate to a heat sink system, the cooling module further including: fourth cooling fins with a fourth cooling fin geometry, the fourth cooling fins downstream of the first cooling fins and upstream of the second cooling fins along the flow of coolant from the inlet port to the outlet port, wherein the fourth cooling fin geometry is a fourth sinusoidal wave having a fourth uniform wavelength that is shorter than the first uniform wavelength and longer than the third uniform wavelength.

In some aspects, the techniques described herein relate to a heat sink system, the cooling module further including: fifth cooling fins with a fifth cooling fin geometry, the fifth cooling fins downstream of the fourth cooling fins and upstream of the second cooling fins along the flow of coolant from the inlet port to the outlet port, wherein the fifth cooling fin geometry is a fifth sinusoidal wave having a fifth uniform wavelength that is shorter than the fourth uniform wavelength and longer than the second uniform wavelength.

In some aspects, the techniques described herein relate to a heat sink system, the cooling module further including: sixth cooling fins with a sixth cooling fin geometry, the sixth cooling fins downstream of the fifth cooling fins and upstream of the second cooling fins along the flow of coolant from the inlet port to the outlet port, wherein the sixth cooling fin geometry is a sixth sinusoidal wave having a sixth uniform wavelength that is equal to the fifth uniform wavelength.

In some aspects, the techniques described herein relate to a heat sink system, wherein the first cooling fins are adjacent to the inlet port and the fourth cooling fins, and wherein the third cooling fins are adjacent to the outlet port and the second cooling fins.

In some aspects, the techniques described herein relate to a heat sink system, further including: a first power module correspondingly positioned with the first cooling fins; a second power module correspondingly positioned with the second cooling fins; a third power module correspondingly positioned with the third cooling fins; a fourth power module correspondingly positioned with the fourth cooling fins; a fifth power module correspondingly positioned with the fifth cooling fins; and a sixth power module correspondingly positioned with the sixth cooling fins, wherein the first heat sink is provided on the first power module, the second power module, the third power module, the fourth power module, the fifth power module, and the sixth power module.

In some aspects, the techniques described herein relate to a heat sink system, wherein the cooling module is configured to equalize a temperature of the first power module, a temperature of the second power module, a temperature of the third power module, a temperature of the fourth power module, a temperature of the fifth power module, and a temperature of the sixth power module when the heat sink system is operational.

In some aspects, the techniques described herein relate to a heat sink system, wherein the cooling module further includes: a first transition zone between the first cooling fins and the second cooling fins, wherein the first transition zone does not include cooling fins.

In some aspects, the techniques described herein relate to a cooling module including: first cooling fins with a first cooling fin geometry, second cooling fins with a second cooling fin geometry, the second cooling fins downstream of the first cooling fins along a flow of coolant from an inlet port to an outlet port, and third cooling fins with a third cooling fin geometry, the third cooling fins downstream of the second cooling fins along the flow of coolant from the inlet port to the outlet port, wherein the first cooling fin geometry is a first sinusoidal wave having a first uniform wavelength, the second cooling fin geometry is a second sinusoidal wave having a second uniform wavelength that is shorter than the first uniform wavelength, and the third cooling fin geometry is a third sinusoidal wave having a third uniform wavelength that is longer than the second uniform wavelength.

In some aspects, the techniques described herein relate to a cooling module, further including: fourth cooling fins with a fourth cooling fin geometry, the fourth cooling fins downstream of the first cooling fins and upstream of the second cooling fins along the flow of coolant from the inlet port to the outlet port, wherein the fourth cooling fin geometry is a fourth sinusoidal wave having a fourth uniform wavelength that is shorter than the first uniform wavelength, longer than the second uniform wavelength, and longer than the third uniform wavelength.

In some aspects, the techniques described herein relate to a cooling module, further including: fifth cooling fins with a fifth cooling fin geometry, the fifth cooling fins downstream of the fourth cooling fins and upstream of the second cooling fins along the flow of coolant from the inlet port to the outlet port, wherein the fifth cooling fin geometry is a fifth sinusoidal wave having a fifth uniform wavelength that is shorter than the fourth uniform wavelength, longer than the second uniform wavelength, and longer than the third uniform wavelength.

In some aspects, the techniques described herein relate to a cooling module, further including: sixth cooling fins with a sixth cooling fin geometry, the sixth cooling fins downstream of the fifth cooling fins and upstream of the second cooling fins along the flow of coolant from the inlet port to the outlet port, wherein the sixth cooling fin geometry is a sixth sinusoidal wave having a sixth uniform wavelength that is shorter than the fourth uniform wavelength, longer than the second uniform wavelength, and longer than the third uniform wavelength.

In some aspects, the techniques described herein relate to a cooling module including: cooling fins including a cooling fin geometry that changes from a first less wavy geometry to a more wavy geometry to a second less wavy geometry in a direction from an inlet port of the cooling module to an outlet port of the cooling module.

In some aspects, the techniques described herein relate to a cooling module, wherein the more wavy geometry is more wavy than the first less wavy geometry and the second less wavy geometry, and the first less wavy geometry is less wavy than the second less wavy geometry.

In some aspects, the techniques described herein relate to a cooling module, wherein the more wavy geometry is more wavy than the first less wavy geometry and the second less wavy geometry, and the first less wavy geometry is more wavy than the second less wavy geometry.

In some aspects, the techniques described herein relate to a cooling module, wherein the more wavy geometry is more wavy than the first less wavy geometry and the second less wavy geometry, and the first less wavy geometry is approximately a same waviness as the second less wavy geometry.

Additional objects and advantages of the disclosed embodiments will be set forth in part in the description that follows, and in part will be apparent from the description, or may be learned by practice of the disclosed embodiments. The objects and advantages of the disclosed embodiments will be realized and attained by means of the elements and combinations particularly pointed out in the appended claims.

It is to be understood that both the foregoing general description and the following detailed description are exemplary and explanatory only and are not restrictive of the disclosed embodiments, as claimed.

### BRIEF DESCRIPTION OF THE DRAWINGS

The accompanying drawings, which are incorporated in and constitute a part of this specification, illustrate various exemplary embodiments and together with the description, serve to explain the principles of the disclosed embodiments.
FIG. 1 depicts an exemplary system infrastructure for a vehicle including a power converter, according to one or more embodiments.
FIG. 2 depicts an exploded view of an exemplary heat sink system including a cooling module, according to one or more embodiments.
FIG. 3 depicts a top view of an exemplary heat sink system including a cooling module with cooling fins, according to one or more embodiments.
FIG. 4A depicts an exemplary cooling assembly including a first heat sink and a power module, according to one or more embodiments.
FIG. 4B depicts the cooling assembly of FIG. 4A and including a second heat sink, according to one or more embodiments.
FIG. 5 depicts an exemplary double-side cooling assembly including a plurality of power modules, according to one or more embodiments.
FIG. 6 depicts a top view of an exemplary heat sink system including a cooling module with cooling fins and transition regions without fins, according to one or more embodiments.
FIG. 7 depicts a top view of an exemplary heat sink system including a cooling module with cooling fins and transition regions including fins, according to one or more embodiments.
FIG. 8 depicts a top view of an exemplary heat sink system including a cooling module with multiple zones of cooling fins, according to one or more embodiments.
FIG. 9 depicts a temperature gradient for a plurality of power modules on a cooling module in an exemplary heat sink system when the heat sink system is operational, according to one or more embodiments.

### DETAILED DESCRIPTION OF EMBODIMENTS

Both the foregoing general description and the following detailed description are exemplary and explanatory only and are not restrictive of the features, as claimed. As used herein, the terms "comprises," "comprising," "has," "having," "includes," "including," or other variations thereof, are intended to cover a non-exclusive inclusion such that a process, method, article, or apparatus that comprises a list of elements does not include only those elements, but may include other elements not expressly listed or inherent to such a process, method, article, or apparatus. In this disclosure, unless stated otherwise, relative terms, such as, for example, "about," "substantially," and "approximately" are used to indicate a possible variation of ±10% in the stated value. In this disclosure, unless stated otherwise, any numeric value may include a possible variation of ±10% in the stated value.

The terminology used below may be interpreted in its broadest reasonable manner, even though it is being used in conjunction with a detailed description of certain specific examples of the present disclosure. Indeed, certain terms may even be emphasized below; however, any terminology intended to be interpreted in any restricted manner will be overtly and specifically defined as such in this Detailed Description section. For example, in the context of the disclosure, the power module may be described as a device, but may refer to any device for controlling the flow of power in an electrical circuit. For example, a power module may be a metal-oxide-semiconductor field-effect transistor (MOSFETs), bipolar junction transistor (BJTs), insulated-gate bipolar transistor (IGBTs), or relays, for example, or any combination thereof, but are not limited thereto.

Thermal management may be considered a key technical aspect in an electric vehicle system. A cooling module may therefore be a critical component in a power converter system, which controls the performance and efficiency of an overall driving system of an electric vehicle. Therefore, improved thermal management with high performance cooling modules may be a demanding technology for performance and reliability of power converters. However, some cooling modules may have limited capability for thermal performance optimization and may have high pressure drop. Some cooling modules with single-side or double-side cooled power modules may have power modules operating at high temperatures, may not provide a well-balanced thermal performance among power modules due to coolant heat-up effect along a coolant flow direction, and may not provide a low pressure drop due to the cooling fin design.

One or more embodiments may include cooling fins which may have changing wavelength (waviness) of the fins in a flow direction of coolant. One or more embodiments may reduce pressure drop in an inverter, which may result in a parasitic loss reduction of a cooling system by reducing the energy consumption of the coolant pump. One or more embodiments may reduce the temperature of a power module, which may result in a higher performance or power density of the inverter, or a longer driving range of an electric vehicle. One or more embodiments may include cooling fins that may provide uniform temperature among power modules, which may improve the performance and reliability of an electric vehicle.

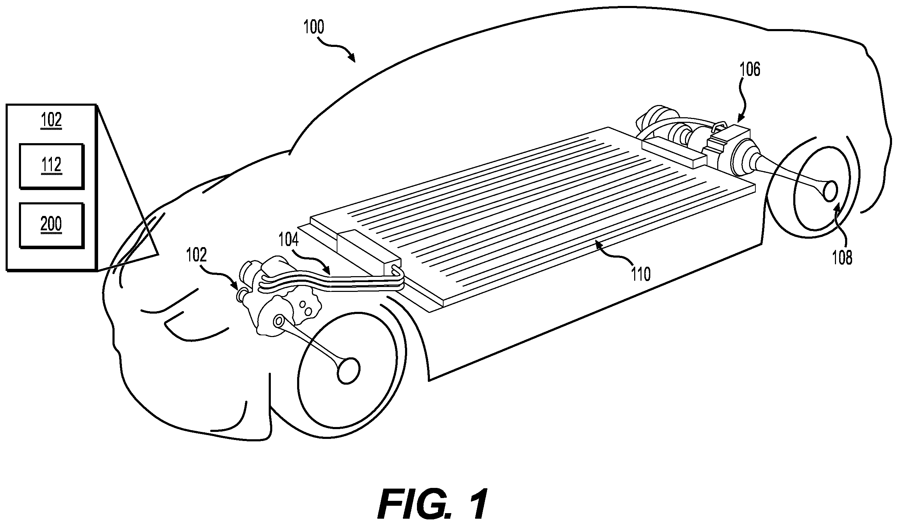

FIG. 1 depicts an exemplary system infrastructure for a vehicle including a power converter, according to one or more embodiments. Electric vehicle 100 may include power converter 102, connectors 104, drive motor 106, wheels 108, and battery 110. Power converter 102 may include power module 112 and heat sink system 200. Heat sink system 200 may be used to cool power module 112. Connectors 104 may connect the power converter 102 and battery 110. Power converter 102 may include components to receive electrical power from an external source and output electrical power to charge battery 110 of electric vehicle 100. Power converter 102, through the use of a power module 112, may convert DC power from battery 110 in electric vehicle 100 to AC power, to power the drive motor 106 and wheels 108 of electric vehicle 100, for example, but the embodiments are not limited thereto. The power converter 102 may be bidirectional, and may convert DC power to AC power, or convert AC power to DC power, such as during regenerative braking, for example. Power converter 102 may be a single-phase inverter, or a multi-phase inverter, such as a three-phase inverter, for example.

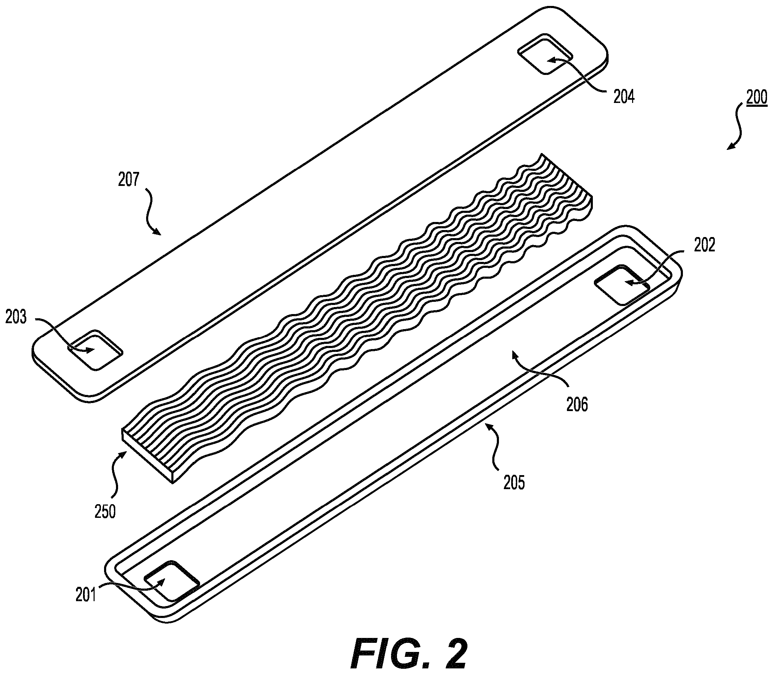

FIG. 2 depicts an exploded view of an exemplary heat sink system including a cooling module, according to one or more embodiments. Heat sink system 200 may include a housing 207, a container 205, and a cooling module 250. The housing 207 may include an inlet port 203 and an outlet port 204. The container 205 may include an inlet port 201, an outlet port 202, and a cavity 206.

The cooling module 250 may be provided between the housing 207 and the container 205. The housing 207 may be in contact with the cooling module 250. The container 205 may be in contact with the cooling module 250. The container 205 may include the cavity 206 where the cooling module 250 may be provided. The inlet port 203 of the housing 207 or the inlet port 201 of the container 205 may be configured to supply a refrigerant (e.g. liquid coolant) to the cavity 206 and the cooling module 250. The outlet port 204 of the housing 207 or the outlet port 202 of the container 205 may be configured to exhaust the refrigerant (e.g., liquid coolant) from the cavity 206 and the cooling module 250.

The heat sink system 200 may include the housing 207 having the inlet port 203 and the outlet port 204, and the container 205 having the inlet port 201 and the outlet port 202, but embodiments are not limited thereto. For example, in one or more embodiments, the housing 207 may not include the inlet port 203 and/or the outlet port 204, and/or the container 205 may not include the inlet port 201 and/or the outlet port 202.

The heat sink system 200 may be configured to provide thermal heat dissipation to (e.g., extract heat from) the power module 112 (e.g., see FIG. 1). A material of the housing 207 and the container 205 of the heat sink system 200 may be selected based on a required thermal performance needed to extract heat from the power module 112. For example, the housing 207 and the container 205 of the heat sink system 200 may include an aluminum alloy having a high thermal conductivity, but embodiments are not limited thereto. For example, the housing 207 and the container 205 of the heat sink system 200 may include copper, but embodiments are not limited thereto. The refrigerant used in the heat sink system 200 may include a circulating fluid of liquid (e.g., liquid coolant) or gas therein, but embodiments are not limited thereto. The heat sink system 200 may be provided in an extruded, folded fin, bonded fin, active fan, stamping, or cross-cut configuration, but embodiments are not limited thereto.

The cooling module 250 may be a continuous, single-folded, metal sheet having a rectangular, circular, or curved geometry, but embodiments are not limited thereto. Similar to the housing 207 and the container 205 of the heat sink system 200, the cooling module 250 may include an aluminum alloy having a high thermal conductivity while being mechanically soft, but embodiments are not limited thereto. The cooling module 250 may include copper, or an alloy of copper and aluminum, for example, but embodiments are not limited thereto.

The cooling module 250 may have cooling fins having an upstream end and a downstream end arranged along a flow of coolant from the inlet ports 201/203 to the outlet ports 202/204. For example, the cooling module 250 may be provided in the cavity 206 with the cooling fins having the upstream end at the inlet port 201 of the container 205 and the downstream end at the outlet port 202 of the container 205, but embodiments are not limited thereto.

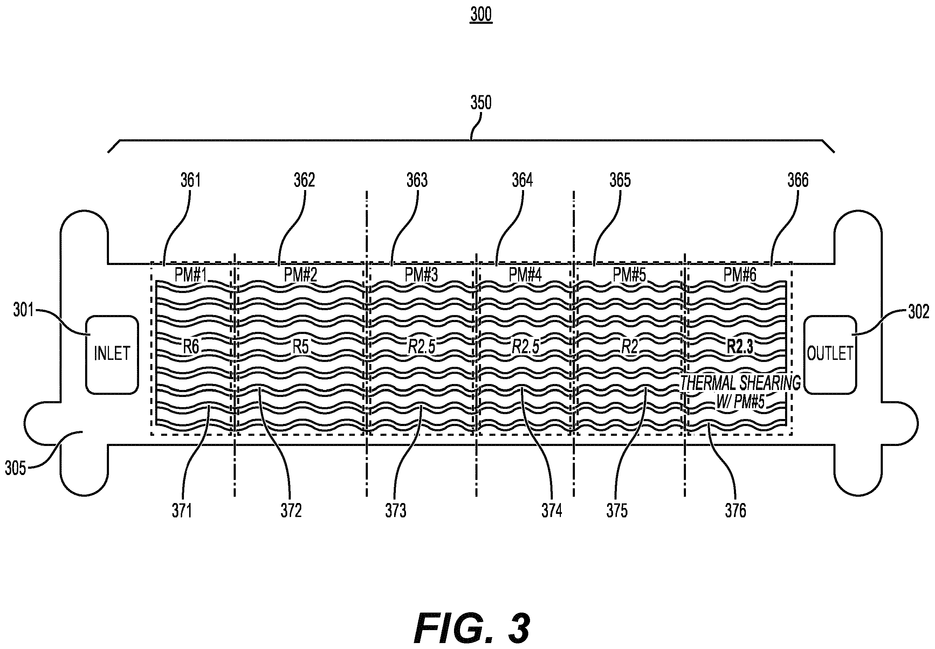

FIG. 3 depicts a top view of an exemplary heat sink system including a cooling module with cooling fins, according to one or more embodiments. Heat sink system 300 may include a container 305, an inlet port 301, an outlet port 302, and a cooling module 350 having cooling fins with an upstream end at the inlet port 301 and a downstream end at the outlet port 302. With reference to FIG. 2, the container 305 may correspond to the container 205, the inlet port 301 may correspond to the inlet port 201, the outlet port 302 may correspond to the outlet port 202, and the cooling module 350 may correspond to the cooling module 250. The cooling module 350 may be provided in a cavity (not shown in FIG. 3) of the container 305. For brevity, the heat sink system 300 of FIG. 3 and the heat sink system 200 of FIG. 2 may contain many similarities which will not be discussed.

The cooling module 350 may include cooling fins with a fin geometry having a sinusoidal wave extending from an upstream end of the cooling module 350 to a downstream end of the cooling module 350. For example, a wavelength (or a pitch, or a frequency) of the sinusoidal wave at the downstream end of the cooling module 350 may be different (e.g., higher waviness/more wavy or lower waviness/less wavy) than a wavelength (or a pitch, or a frequency) of the sinusoidal wave at the upstream end of the cooling module 350 (e.g., lower waviness/less wavy or higher waviness/more wavy). For example, the wavelength of the sinusoidal wave of the cooling fins may vary depending on a section or zone of the cooling module 350. The cooling module 350 may include cooling fins that increase in wavelength from zone to zone in a direction from the upstream end of the cooling module 350 to a downstream end of the cooling module 350 and cooling fins that decrease in wavelength from zone to zone in a direction from the upstream end of the cooling module 350 to a downstream end of the cooling module 350.

As depicted in FIG. 3, the cooling module 350 may include a first cooling zone 361, a second cooling zone 362, a third cooling zone 363, a fourth cooling zone 364, a fifth cooling zone 365, and a sixth cooling zone 366, but embodiments are not limited thereto. First cooling zone 361 may be adjacent to inlet port 301 and second cooling zone 362, second cooling zone 362 may be adjacent to first cooling zone 361 and third cooling zone 363, third cooling zone 363 may be adjacent to second cooling zone 362 and fourth cooling zone 364, fourth cooling zone 364 may be adjacent to third cooling zone 363 and fifth cooling zone 365, fifth cooling zone 365 may be adjacent to fourth cooling zone 364 and sixth cooling zone 366, and sixth cooling zone 366 may be adjacent to fifth cooling zone 365 and outlet port 302.

The first cooling zone 361 may include cooling fins with a sinusoidal wave having a first pitch 371 (R6). The second cooling zone 362 may include cooling fins with a sinusoidal wave having a second pitch 372 (R5). The third cooling zone 363 may include cooling fins with a sinusoidal wave having a third pitch 373 (R2.5). The fourth cooling zone 364 may include cooling fins with a sinusoidal wave having a fourth pitch 374 (R2.5). The fifth cooling zone 365 may include cooling fins with a sinusoidal wave having a fifth pitch 375 (R2). The sixth cooling zone 366 may include cooling fins with a sinusoidal wave having a sixth pitch 376 (R2.3). The third pitch 373 (R2) and the fourth pitch 374 (R2) may be similar or substantially similar. The pitches described herein may range from approximately 0.5 mm to approximately 20 mm. For example, first pitch 371 (R6) may correspond to approximately a 1.5 mm pitch.

The first pitch 371 (R6) may have a lower frequency (e.g., larger radius, longer wavelength) than the second pitch 372 (R5). The second pitch 372 (R5) may have a lower frequency (e.g., larger radius, longer wavelength) than the third pitch 373 (R2.5). The third pitch 373 (R2.5) may have a similar frequency (e.g., similar radius, equal wavelength) as the fourth pitch 374 (R2.5). The third pitch 373 (R2.5) may have a higher frequency (e.g., smaller radius, shorter wavelength) than the fourth pitch 374 (R2.5). The fourth pitch 374 (R2.5) may have a lower frequency (e.g., larger radius, longer wavelength) than the fifth pitch 375 (R2). The fifth pitch 375 (R2) may have a higher frequency (e.g., smaller radius, shorter wavelength) than the sixth pitch 376 (R2.3). The fifth pitch 375 (R2) may have a similar frequency as the third pitch 373 (R2.5). However, the above description is only exemplary and embodiments are not limited thereto.

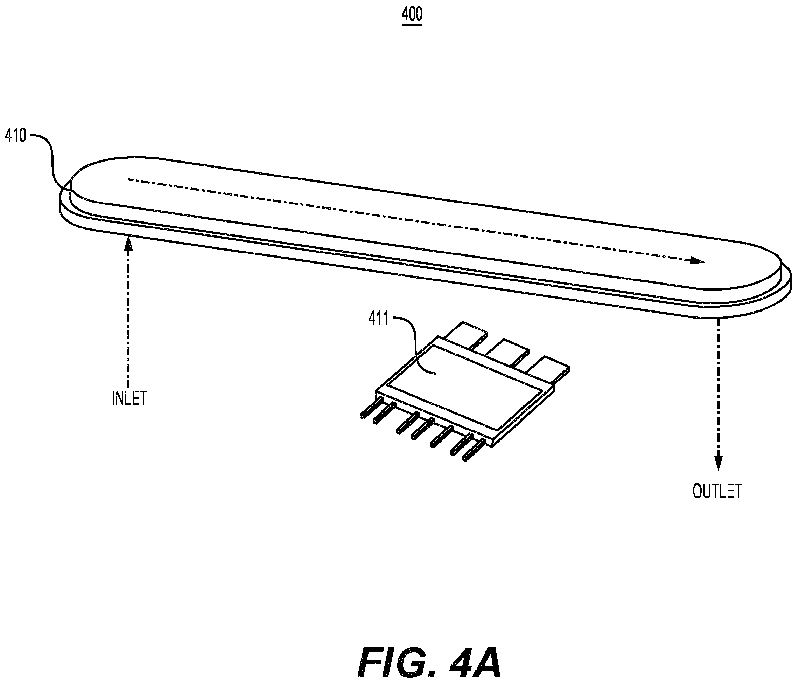

FIG. 4A depicts an exemplary cooling assembly including a first heat sink and a power module, according to one or more embodiments. Single-side cooling assembly 400 may include a first heat sink system 410 and a power module 411. The first heat sink system 410 may correspond to the heat sink system 300 of FIG. 3 and the power module 411 may correspond to the power module 112 of FIG. 1.

The first heat sink system 410 may include an inlet port and an outlet port (not shown in FIG. 4A). The inlet port may be configured to supply (or introduce) a flow of coolant to the first heat sink system 410 and the outlet port may be configured to exhaust the flow of coolant in the first heat sink system 410, which is depicted by the arrows in FIG. 4A.

The power module 411 has a first side surface and a second side surface. In one or more embodiments, the first heat sink system 410 may be configured to be provided on the first side surface or the second side surface of the power module 411 (e.g., on a single side surface) to extract heat from the power module 411.

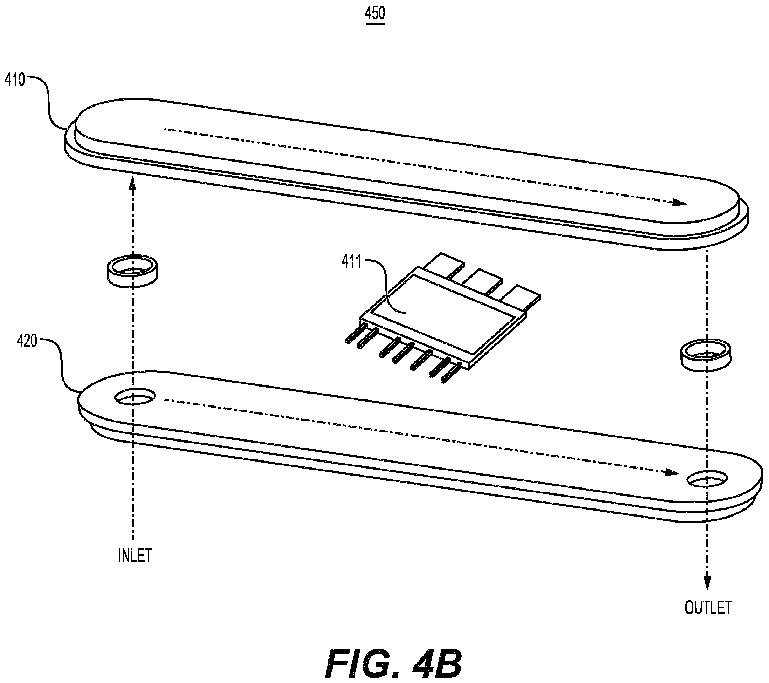

FIG. 4B depicts the cooling assembly of FIG. 4A including a second heat sink system, according to one or more embodiments. Double-side cooling assembly 450 may include the first heat sink system 410, a second heat sink system 420, and the power module 411. The first heat sink system 410 and the second heat sink system 420 may each correspond to the heat sink system 300 of FIG. 3 and the power module 411 may correspond to the power module 112 of FIG. 1.

The first heat sink system 410 may include an inlet port and an outlet port (not shown in FIG. 4B). The inlet port may be configured to supply (or introduce) a flow of coolant to the first heat sink system 410 and the outlet port may be configured to exhaust the flow of coolant in the first heat sink system 410, which is depicted by the arrows in FIG. 4B.

The second heat sink system 420 may include an inlet port and an outlet port (not shown in FIG. 4B). The inlet port may be configured to supply (or introduce) a flow of coolant to the second heat sink system 420 and the outlet port may be configured to exhaust the flow of coolant in the second heat sink system 420, which is depicted by the arrows in FIG. 4B.

The flow of coolant supplied into the first heat sink system 410 may be supplied from the inlet port of the second heat sink system 420, but embodiments are not limited thereto. The flow of coolant exhausted through the outlet port of the first heat sink system 410 may be exhausted to the outlet port of the second heat sink system 420, and the outlet port of the second heat sink system 420 may exhaust the flow of coolant exhausted by the first heat sink system 410 and the flow of coolant in the second heat sink system 420, but embodiments are not limited thereto.

The power module 411 has a first side surface and a second side surface. In one or more embodiments, the first heat sink system 410 may be configured to be provided on a first side surface of the power module 411 and the second heat sink system 420 may be configured to be provided on a second side surface of the power module 411 to extract heat from the power module 411.

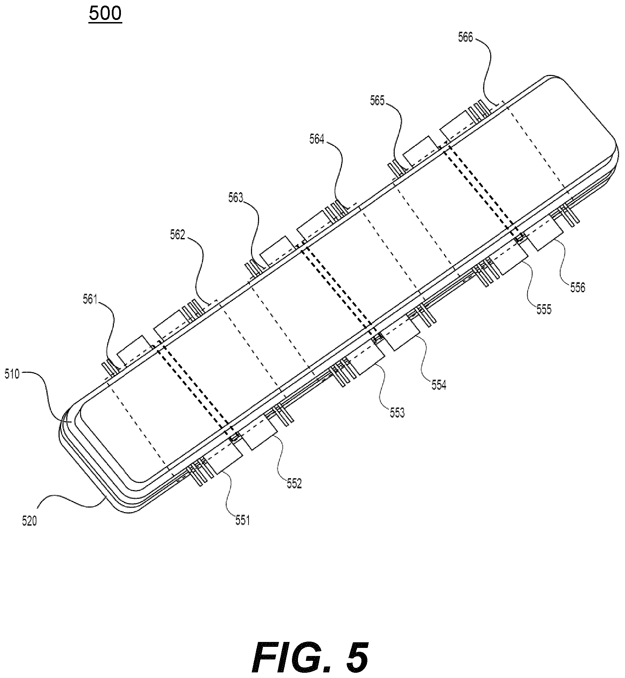

FIG. 5 depicts an exemplary double-side cooling assembly including a plurality of power modules, according to one or more embodiments. Double-side cooling assembly 500 may include a first heat sink system 510, a second heat sink system 520, and a plurality of power modules including a first power module 551, a second power module 552, a third power module 553, a fourth power module 554, a fifth power module 555, and a sixth power module 556. The first heat sink system 510 and the second heat sink system 520 may each be the heat sink system 300 of FIG. 3. For example, the first heat sink system 510 and the second heat sink system 520 may each include a first cooling zone 561, a second cooling zone 562, a third cooling zone 563, a fourth cooling zone 564, a fifth cooling zone 565, and a sixth cooling zone 566.

The first cooling zone 561, the second cooling zone 562, the third cooling zone 563, the fourth cooling zone 564, the fifth cooling zone 565, and the sixth cooling zone 566 may correspond to the first cooling zone 361, the second cooling zone 362, the third cooling zone 363, the fourth cooling zone 364, the fifth cooling zone 365, and the sixth cooling zone 366 of cooling module 350 of FIG. 3. Each of the plurality of power modules may correspond to power module 112 of FIG. 1. For brevity, the double-side cooling assembly 500 of FIG. 5 and the double-side cooling assembly 450 in FIG. 4B may contain many similarities which will not be discussed. For brevity of description, only distinctions between the double-side cooling assembly 500 and the double-side cooling assembly 450 will be described.

The plurality of power modules including the first power module 551, the second power module 552, the third power module 553, the fourth power module 554, the fifth power module 555, and the sixth power module 556 may each correspond to the power module 112 of FIG. 1. For example, the power module 112 may be a three-phase power module for a three-phase system, but embodiments are not limited thereto.

The first power module 551, the second power module 552, the third power module 553, the fourth power module 554, the fifth power module 555, and the sixth power module 556 may each have a first side surface and a second side surface. The first heat sink system 510 may be provided on the first side surface of the first power module 551, the first side surface of the second power module 552, the first side surface of the third power module 553, the first side surface of the fourth power module 554, the first side surface of the fifth power module 555, and the first side surface of the sixth power module 556. The second heat sink system 520 may be provided on the second side surface of the first power module 551, the second side surface of the second power module 552, the second side surface of the third power module 553, the second side surface of the fourth power module 554, the second side surface of the fifth power module 555, and the second side surface of the sixth power module 556. That is, the double-side cooling assembly 500 may be configured to extract heat from both side surfaces of the plurality of power modules.

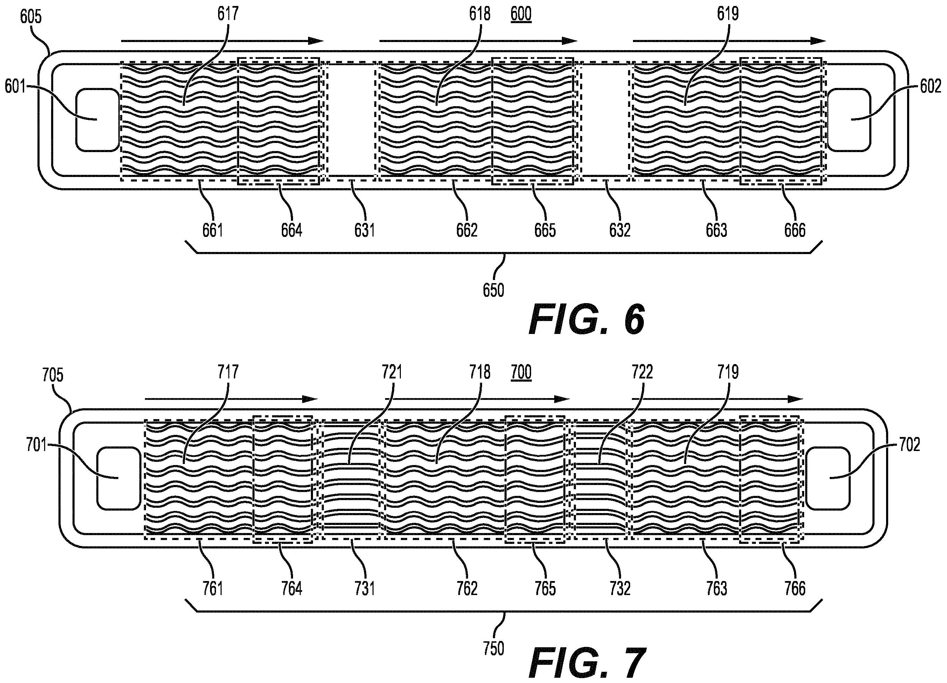

FIG. 6 depicts a top view of an exemplary heat sink system including a cooling module with cooling fins and transition regions without fins, according to one or more embodiments. Heat sink system 600 may include a container 605, an inlet port 601, an outlet port 602, and a cooling module 650. The cooling module 650 may be provided in a cavity (not shown in FIG. 6) of the container 605. The cooling module 650 may include a first cooling zone 661, a second cooling zone 662, a third cooling zone 663, a first transition zone 631, and a second transition zone 632. Cooling module 650 may include a first sub-zone 664 within first cooling zone 661, a second sub-zone 665 within second cooling zone 662, and a third sub-zone 666 within third cooling zone 663. For brevity, the heat sink system 600 of FIG. 6 and the heat sink system 300 of FIG. 3 may contain many similarities which will not be discussed. For brevity of description, only distinctions between the heat sink system 600 and the heat sink system 300 will be described.

The first cooling zone 661 may include a first cooling fin 617. The first cooling fin 617 may include an upstream end and a downstream end. The first cooling fin 617 may progressively change. For example, the first cooling fin 617 near the downstream end (e.g., first sub-zone 664 within the first cooling zone 661 closest to first transition zone 631) may have a different pitch than the first cooling fin 617 near the upstream end. Specifically, as seen in FIG. 6, the first cooling fin 617 near the downstream end at first sub-zone 664 may have a lower frequency (e.g., larger radius) than the rest of the first cooling fin 617 within first cooling zone 661. The first cooling fin 617 may include a fin geometry having a continuously progressive sinusoidal wave extending from an upstream end of the first cooling fin 617 to a downstream end of the first cooling fin 617. For example, a wavelength of the continuously progressive sinusoidal wave at the downstream end of the first cooling fin 617 may be longer (e.g., low waviness or less wavy) than a wavelength of the continuously progressive sinusoidal wave at the upstream end of the first cooling fin 617 (e.g., high waviness or more wavy).

The second cooling zone 662 may include second cooling fin 618. The second cooling fin 618 may include an upstream end and a downstream end. The second cooling fin 618 may progressively change. For example, the second cooling fin 618 near the downstream end (e.g., second sub-zone 665 within the second cooling zone 662 closest to second transition zone 632) may have a different pitch than the second cooling fin 618 near the upstream end. Specifically, as seen in FIG. 6, the second cooling fin 618 near the downstream end at second sub-zone 665 may have a lower frequency (e.g., larger radius) than the rest of second cooling fin 618 within second cooling zone 662. The second cooling fin 618 may include a fin geometry having a continuously progressive sinusoidal wave extending from an upstream end of the second cooling fin 618 to a downstream end of the second cooling fin 618. For example, a wavelength of the continuously progressive sinusoidal wave at the downstream end of the second cooling fin 618 may be longer (e.g., low waviness or less wavy) than a wavelength of the continuously progressive sinusoidal wave at the upstream end of the second cooling fin 618 (e.g., high waviness or more wavy).

The third cooling zone 663 may include third cooling fin 619. The third cooling fin 619 may include an upstream end and a downstream end. The third cooling fin 619 may progressively change. For example, the third cooling fin 619 near the downstream end (e.g., third sub-zone 666 within the third cooling zone 663 closest to third transition zone 633) may have a different pitch than the third cooling fin 619 near the upstream end. Specifically, as seen in FIG. 6, the third cooling fin 619 near the downstream end at third sub-zone 666 may have a lower frequency (e.g., larger radius) than the rest of third cooling fin 619 within third cooling zone 663. The third cooling fin 619 may include a fin geometry having a continuously progressive sinusoidal wave extending from an upstream end of the third cooling fin 619 to a downstream end of the third cooling fin 619. For example, a wavelength of the continuously progressive sinusoidal wave at the downstream end of the third cooling fin 619 may be longer (e.g., low waviness or less wavy) than a wavelength of the continuously progressive sinusoidal wave at the upstream end of the third cooling fin 619 (e.g., high waviness or more wavy).

Although FIG. 6 depicts the cooling module 650 with three cooling zones (e.g., the first cooling zone 661, the second cooling zone 662, and the third cooling zone 663), the cooling module 650 may include one or more cooling zones. For example, cooling module 650 may include five or more cooling zones.

The first transition zone 631 does not include cooling fins. The first transition zone 631 may include an upstream end and a downstream end. The first transition zone 631 may be arranged between the first cooling zone 661 and the second cooling zone 662 such that the upstream end of the first transition zone 631 is connected to (or in contact with) a downstream end of the first cooling zone 661 (e.g., first sub-zone 664), and the downstream end of the first transition zone 631 is connected to (or in contact with) an upstream end of the second cooling zone 662, but embodiments are not limited thereto.

The second transition zone 632 does not include cooling fins. The second transition zone 632 may include an upstream end and a downstream end. The second transition zone 632 may be arranged between the second cooling zone 662 and the third cooling zone 663 such that the upstream end of the second transition zone 632 is connected to (or in contact with) a downstream end of the second cooling zone 662 (e.g., second sub-zone 665), and the downstream end of the second transition zone 632 is connected to (or in contact with) an upstream end of the third cooling zone 663, but embodiments are not limited thereto.

FIG. 7 depicts a top view of an exemplary heat sink system including a cooling module with cooling fins and transition regions including fins, according to one or more embodiments. Heat sink system 700 may include a container 705, an inlet port 701, an outlet port 702, and a cooling module 750. The cooling module 750 may be provided in a cavity (not shown in FIG. 7) of the container 705. The cooling module 750 may include a first cooling zone 761 having first cooling fin 717, a second cooling zone 762 having second cooling fin 718, a third cooling zone 763 having third cooling fin 719, a first transition zone 731, and a second transition zone 732. The cooling module 750 may also include a first sub-zone 764 within first cooling zone 761, a second sub-zone 765 within second cooling zone 762, and a third sub-zone 766 within third cooling zone 763. For brevity, the heat sink system 700 of FIG. 7 and the heat sink system 600 of FIG. 6 may contain many similarities (e.g., the fin 717 having a different pitch within first sub-zone 764, the second cooling fin 718 having a different pitch within second sub-zone 765, and the third cooling fin 719 having a different pitch within third sub-zone 766) which will not be discussed. For brevity of description, only distinctions between the heat sink system 700 and the heat sink system 600 will be described.

The first transition zone 731 may include a first transition zone cooling fin 721 with a flat fin geometry having a flat wave (or substantially flat wave, or a straight fin geometry) corresponding to an infinite wavelength (or a large radius geometry, for example). The first transition zone 731 may include an upstream end and a downstream end. The first transition zone 731 may be arranged between the first cooling zone 761 and the second cooling zone 762 such that the upstream end of the first transition zone 731 is connected to (or in contact with) a downstream end of the first cooling zone 761 (e.g., first sub-zone 764 that includes fin 717 with a less wavy fin), and the downstream end of the first transition zone 731 is connected to (or in contact with) an upstream end of the second cooling zone 762.

The second transition zone 732 may include a second transition zone cooling fin 722 with a flat fin geometry having a flat wave (or substantially flat wave) corresponding to an infinite wavelength. The second transition zone 732 may include an upstream end and a downstream end. The second transition zone 732 may be arranged between the second cooling zone 762 and the third cooling zone 763 such that the upstream end of the second transition zone 732 is connected to (or in contact with) a downstream end of the second cooling zone 762 (e.g., second sub-zone 765 that includes second cooling fin 718 with a less wavy fin), and the downstream end of the second transition zone 732 is connected to (or in contact with) an upstream end of the third cooling zone 763. The transition zone cooling fins of the first transition zone 731 and the second transition zone 732 may each have a flat fin geometry having a flat wave (or substantially flat wave) corresponding to an infinite wavelength, but embodiments are not limited thereto.

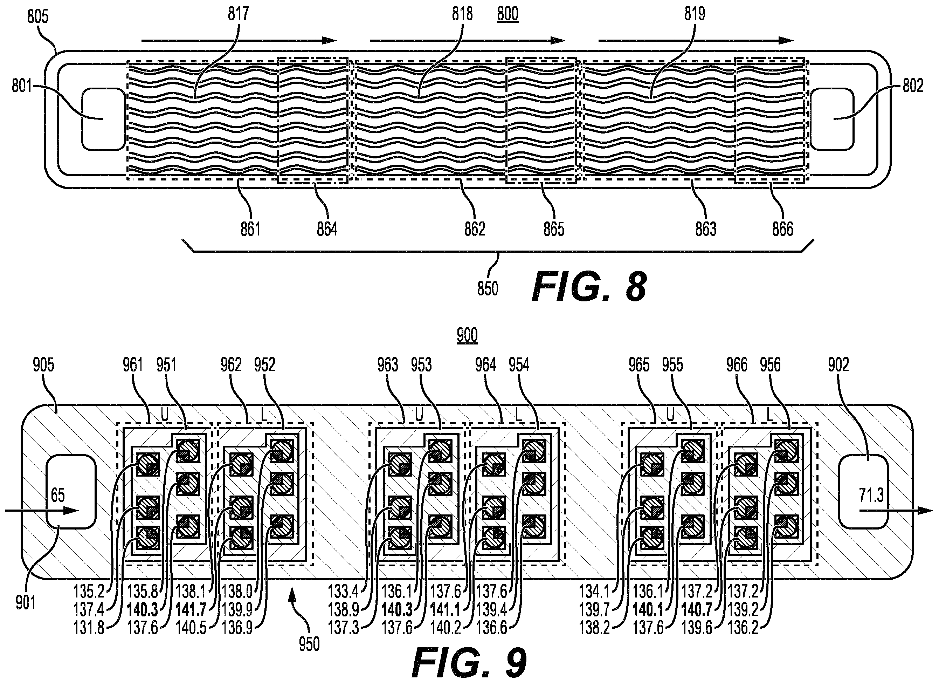

FIG. 8 depicts a top view of an exemplary heat sink system including a cooling module with cooling fins, according to one or more embodiments. Heat sink system 800 may include a container 805, an inlet port 801, an outlet port 802, and a cooling module 850. The cooling module 850 may be provided in a cavity (not shown in FIG. 8) of the container 805. The cooling module 850 may include a first cooling zone 861 having first cooling fin 817, a second cooling zone 862 having second cooling fin 818, and a third cooling zone 863 having third cooling fin 819. The cooling module 750 may also include a first sub-zone 864 within first cooling zone 861, a second sub-zone 865 within second cooling zone 862, and a third sub-zone 866 within third cooling zone 863. The cooling module 850 may not include transition zones. For brevity, the heat sink system 800 of FIG. 8 and the heat sink system 600 of FIG. 6 may contain many similarities which will not be discussed. For brevity of description, only distinctions between the heat sink system 800 and the heat sink system 600 will be described.

The third cooling fin 819 may be provided in the container 805 at the outlet port 802, at a downstream position in the container 805 in a direction of the flow of coolant. The first cooling fin 817 may be provided in the container 805 at the inlet port 801, upstream of the flow of coolant. The second cooling fin 818 may be provided in the container 805, upstream of the third cooling fin 819, and downstream of the first cooling fin 817. In other words, the second cooling fin 818 may be provided between the first cooling fin 817 and the third cooling fin 819 such that the downstream end of the first cooling fin 817 (e.g., the first cooling fin 817 within first sub-zone 864) may be connected to (or in contact with) the upstream end of the second cooling fin 818, and the downstream end of the second cooling fin 818 (e.g., the second cooling fin 818 within second sub-zone 865) may be connected to (or in contact with) the upstream end of the third cooling fin 819.

FIG. 9 depicts a temperature gradient for a plurality of power modules on a cooling module in an exemplary heat sink system when the heat sink system is operational, according to one or more embodiments. Heat sink system 900 may include an inlet port 901, an outlet port 902, a container 905, a cooling module 950, and a plurality of power modules including a first power module 951, a second power module 952, a third power module 953, a fourth power module 954, a fifth power module 955, and a sixth power module 956. Heat sink system 900 may be the heat sink system 300 of FIG. 3.

For example, heat sink system 900 may include a first cooling zone 961, a second cooling zone 962, a third cooling zone 963, a fourth cooling zone 964, a fifth cooling zone 965, and a sixth cooling zone 966. The first cooling zone 961, the second cooling zone 962, the third cooling zone 963, the fourth cooling zone 964, the fifth cooling zone 965, and the sixth cooling zone 966 may correspond to the first cooling zone 361, the second cooling zone 362, the third cooling zone 363, the fourth cooling zone 364, the fifth cooling zone 365, and the sixth cooling zone 366 of cooling module 350 of FIG. 3. The plurality of power modules may correspond to power module 112 of FIG. 1. For brevity, the heat sink system 900 of FIG. 9 and the heat sink system 300 in FIG. 3 may contain many similarities which will not be discussed. For brevity of description, only temperature-related disclosure will be described below.

The temperature values depicted in FIG. 9 and described herein are exemplary. For example, the temperature of the coolant entering inlet port 901 may be 65 degrees Celsius and the temperature of the coolant exiting outlet port 902 may be 71.3 degrees Celsius. It is important to have uniform temperature throughout heat sink system 900 to improve performance and reliability of the power modules. As seen in FIG. 9, each of first power module 951, second power module 952, third power module 953, fourth power module 954, fifth power module 955, and sixth power module 956 have six dies, and each die has similar (e.g., equalized) temperature values (e.g., the dies are about 140 degrees Celsius).

The coolant temperature increases from inlet port 901 to outlet port 902 as each power module acts as a heat source. Power modules "sandwiched" between two neighboring power modules (e.g., second power module 952, third power module 953, fourth power module 954, and fifth power module 955) radiate more heat than the power modules at the ends (e.g., first power module 951 and sixth power module 956) of cooling module 950 because the neighboring power modules contribute to the heat output. Thus, compensating for the temperature increase of coolant from inlet port 901 to outlet port 902 due to the heat radiated from each power module may not be a simple, progressively wavier fin design. Instead, it may be more cost effective and generally more efficient to have a fin design that is the waviest (e.g., the highest frequency) prior to the last power module closest to the outlet port, such as the fin design described herein.

The fin design described herein (e.g., the specific pitch values for each cooling zone) may properly compensate for the temperature increase and, therefore, may normalize the temperature at each power module, as seen in FIG. 9. Since the coolant increases in temperature when traveling through cooling module 950, the second to last power module (e.g., fifth power module 955) may be the hottest because fifth power module 955 not only has two neighboring power modules (e.g., fourth power module 954 and sixth power module 956) but fifth power module 955 also receives the coolant at a temperature substantially higher than the temperature of the coolant close to inlet port 901 as the coolant has traveled past first power module 951, second power module 952, third power module 953, and fourth power module 954. Therefore, fifth power module 955 may require the highest frequency. If the frequency was the highest (e.g., the fin was waviest) at sixth cooling zone 966 (e.g., sixth cooling zone 366), the temperature of sixth power module 956 may be substantially less than the temperature of the other five power modules (e.g., first power module 951, second power module 952, third power module 953, fourth power module 954, and fifth power module 955) and, thus, the temperature may not be uniform throughout the heat sink system 900. The cooling module 950 itself may have uniform temperature as well due to the uniform temperature throughout the power modules.

According to one or more embodiments, a cooling module may include six cooling zones with four or more fin geometries. According to one or more embodiments, a cooling module may include cooling zones with different pitches in each cooling zone and/or a same pitch in two or more cooling zones. One or more embodiments may include a cooling module configured to extract heat from six power modules. One or more embodiments may include a cooling module designed to provide uniform temperatures along a plurality of power modules.

According to one or more embodiments, cooling modules having cooling fins with a sinusoidal wave may provide a uniform temperature distribution for one or more power modules. The sinusoidal wave fins may reduce a pressure drop in one or more power modules and may result in parasitic loss reduction of heat sink systems, which may ultimately result in higher performance, higher power density and/or longer drive range of electric vehicles.

According to one or more embodiments, cooling modules may include cooling fins which may have sinusoidal waves with changing wavelengths (waviness) of the fins in a flow direction of coolant, which may reduce pressure drop in an inverter, which may result in a parasitic loss reduction of a cooling system by reducing the energy consumption of the coolant pump. Cooling modules with cooling fins having sinusoidal waves with changing wavelengths (waviness) of the fins in a flow direction of coolant may also help improve heat transfer in the direction of the flow of the coolant.

Accordingly to one or more embodiments, heat sink systems with cooling modules having cooling fins with a sinusoidal wave may reduce the temperature of one or more power modules, which may result in a higher performance or power density of the inverter, and/or a longer driving range of an electric vehicle, and/or may provide uniform temperature among one or more power modules, which may improve the performance and reliability of an electric vehicle.

Other embodiments of the disclosure will be apparent to those skilled in the art from consideration of the specification and practice of the invention disclosed herein. It is intended that the specification and examples be considered as exemplary only, with the true scope of the invention being indicated by the following claims.

## Claims

1. A heat sink system comprising a first heat sink including:
a container including a cavity;
a housing connecting to the container to cover the cavity, wherein one or more of the container or the housing includes an inlet port, and one or more of the container or the housing includes an outlet port; and
a cooling module in the cavity between the container and the housing, the cooling module in a flow of coolant from the inlet port to the outlet port,
wherein the cooling module includes:
first cooling fins with a first cooling fin geometry,
second cooling fins with a second cooling fin geometry, the second cooling fins downstream of the first cooling fins along the flow of coolant from the inlet port to the outlet port, and
third cooling fins with a third cooling fin geometry, the third cooling fins downstream of the second cooling fins along the flow of coolant from the inlet port to the outlet port,
wherein the first cooling fin geometry is a first sinusoidal wave having a first uniform wavelength, the second cooling fin geometry is a second sinusoidal wave having a second uniform wavelength that is shorter than the first uniform wavelength, and the third cooling fin geometry is a third sinusoidal wave having a third uniform wavelength that is longer than the second uniform wavelength.

2. The heat sink system of claim 1, further comprising:
one or more power modules, wherein the first heat sink is provided on the one or more power modules.

3. The heat sink system of claim 2, further comprising a second heat sink,
wherein the one or more power modules include:
a first power module;
a second power module;
a third power module;
a fourth power module;
a fifth power module; and
a sixth power module,
wherein the first heat sink is provided on a first side surface of the first power module, a first side surface of the second power module, a first side surface of the third power module, a first side surface of the fourth power module, a first side surface of the fifth power module, and a first side surface of the sixth power module, and
wherein the second heat sink is provided on a second side surface of the first power module, a second side surface of the second power module, a second side surface of the third power module, a second side surface of the fourth power module, a second side surface of the fifth power module, and a second side surface of the sixth power module.

4. An inverter comprising the heat sink system of claim 1.

5. A vehicle comprising the inverter of claim 4.

6. The heat sink system of any one of claims 1 to 5, the cooling module further including:
fourth cooling fins with a fourth cooling fin geometry, the fourth cooling fins downstream of the first cooling fins and upstream of the second cooling fins along the flow of coolant from the inlet port to the outlet port, wherein the fourth cooling fin geometry is a fourth sinusoidal wave having a fourth uniform wavelength that is shorter than the first uniform wavelength and longer than the third uniform wavelength.

7. The heat sink system of claim 6, the cooling module further including:
fifth cooling fins with a fifth cooling fin geometry, the fifth cooling fins downstream of the fourth cooling fins and upstream of the second cooling fins along the flow of coolant from the inlet port to the outlet port, wherein the fifth cooling fin geometry is a fifth sinusoidal wave having a fifth uniform wavelength that is shorter than the fourth uniform wavelength and longer than the second uniform wavelength.

8. The heat sink system of claim 7, the cooling module further including:
sixth cooling fins with a sixth cooling fin geometry, the sixth cooling fins downstream of the fifth cooling fins and upstream of the second cooling fins along the flow of coolant from the inlet port to the outlet port, wherein the sixth cooling fin geometry is a sixth sinusoidal wave having a sixth uniform wavelength that is equal to the fifth uniform wavelength.

9. The heat sink system of claim 8, wherein the first cooling fins are adjacent to the inlet port and the fourth cooling fins, and wherein the third cooling fins are adjacent to the outlet port and the second cooling fins;
and/or wherein the heat sink system further comprises:
a first power module correspondingly positioned with the first cooling fins;
a second power module correspondingly positioned with the second cooling fins;
a third power module correspondingly positioned with the third cooling fins;
a fourth power module correspondingly positioned with the fourth cooling fins;
a fifth power module correspondingly positioned with the fifth cooling fins; and
a sixth power module correspondingly positioned with the sixth cooling fins,
wherein the first heat sink is provided on the first power module, the second power module, the third power module, the fourth power module, the fifth power module, and the sixth power module.

10. The heat sink system of claim 9, wherein the cooling module is configured to equalize a temperature of the first power module, a temperature of the second power module, a temperature of the third power module, a temperature of the fourth power module, a temperature of the fifth power module, and a temperature of the sixth power module when the heat sink system is operational.

11. The heat sink system of any one of claims 1 to 10, wherein the cooling module further includes:
a first transition zone between the first cooling fins and the second cooling fins,
wherein the first transition zone does not include cooling fins.

12. A cooling module comprising:
first cooling fins with a first cooling fin geometry,
second cooling fins with a second cooling fin geometry, the second cooling fins downstream of the first cooling fins along a flow of coolant from an inlet port to an outlet port, and
third cooling fins with a third cooling fin geometry, the third cooling fins downstream of the second cooling fins along the flow of coolant from the inlet port to the outlet port,
wherein the first cooling fin geometry is a first sinusoidal wave having a first uniform wavelength, the second cooling fin geometry is a second sinusoidal wave having a second uniform wavelength that is shorter than the first uniform wavelength, and the third cooling fin geometry is a third sinusoidal wave having a third uniform wavelength that is longer than the second uniform wavelength.

13. The cooling module of claim 12, further comprising:
fourth cooling fins with a fourth cooling fin geometry, the fourth cooling fins downstream of the first cooling fins and upstream of the second cooling fins along the flow of coolant from the inlet port to the outlet port, wherein the fourth cooling fin geometry is a fourth sinusoidal wave having a fourth uniform wavelength that is shorter than the first uniform wavelength, longer than the second uniform wavelength, and longer than the third uniform wavelength.

14. The cooling module of claim 13, further comprising:
fifth cooling fins with a fifth cooling fin geometry, the fifth cooling fins downstream of the fourth cooling fins and upstream of the second cooling fins along the flow of coolant from the inlet port to the outlet port, wherein the fifth cooling fin geometry is a fifth sinusoidal wave having a fifth uniform wavelength that is shorter than the fourth uniform wavelength, longer than the second uniform wavelength, and longer than the third uniform wavelength;
and preferably, further comprising:
sixth cooling fins with a sixth cooling fin geometry, the sixth cooling fins downstream of the fifth cooling fins and upstream of the second cooling fins along the flow of coolant from the inlet port to the outlet port, wherein the sixth cooling fin geometry is a sixth sinusoidal wave having a sixth uniform wavelength that is shorter than the fourth uniform wavelength, longer than the second uniform wavelength, and longer than the third uniform wavelength.

15. A cooling module comprising:
cooling fins including a cooling fin geometry that changes from a first less wavy geometry to a more wavy geometry to a second less wavy geometry in a direction from an inlet port of the cooling module to an outlet port of the cooling module;
wherein, preferably, the more wavy geometry is more wavy than the first less wavy geometry and the second less wavy geometry, and the first less wavy geometry is less wavy than the second less wavy geometry.
and/or
wherein, preferably, the more wavy geometry is more wavy than the first less wavy geometry and the second less wavy geometry, and the first less wavy geometry is more wavy than the second less wavy geometry.
and/or
wherein, preferably, the more wavy geometry is more wavy than the first less wavy geometry and the second less wavy geometry, and the first less wavy geometry is approximately a same waviness as the second less wavy geometry.
